# EUROPEAN PATENT SPECIFICATION

(11) **EP 3 926 703 B1**
(45) Date of publication and mention of the grant of the patent: **20.03.2024**
(21) Application number: 20382514.6
(22) Date of filing: 15.06.2020
(51) Int. Cl.: H10K 71/18, H10K 71/20, H10K 71/30, H10K 71/40, H10K 85/10, H10K 85/60

(54) **METHOD FOR PROVIDING A STRUCTURAL AND/OR A COMPOSITIONAL MODIFICATION IN A MOLECULAR SEMICONDUCTOR TARGET FILM**
VERFAHREN ZUR BEREITSTELLUNG EINER STRUKTURELLEN UND/ODER EINER KOMPOSITIONELLEN MODIFIZIERUNG IN EINEM MOLEKULAREN HALBLEITERZIELFILM
PROCÉDÉ DE FOURNITURE D'UNE MODIFICATION DE STRUCTURE ET/OU DE COMPOSITION DANS UN FILM CIBLE MOLÉCULAIRE À SEMICONDUCTEURS

(43) Date of publication of application: 22.12.2021
(73) Proprietor: Consejo Superior de Investigaciones Científicas (CSIC), 28006 Madrid (ES)
(72) Inventor: CAMPOY QUILES, Mariano, 08193 Cerdanyola del Vallès (Barcelona) (ES); PEREVEDENTSEV, Aleksandr, 08193 Cerdanyola del Vallès (Barcelona) (ES)
(74) Representative: Torner, Juncosa I Associats, SL

(56) References cited:
- F. PSCHENITZKA ET AL: "Solvent-enhanced Dye Diffusion in Polymer This-Films for OLED Application", MATERIALS RESEARCH SOCIETY SYMPOSIUM PROCEEDINGS, vol. 665, 31 December 2001 (2001-12-31), XP055746359, US ISSN: 0272-9172, DOI: 10.1557/PROC-665-C9.5
- PSCHENITZKA F ET AL: "THREE-COLOR ORGANIC LIGHT-EMITTING DIODES PATTERNED BY MASKED DYE DIFFUSION", APPLIED PHYSICS LETTERS, A I P PUBLISHING LLC, US, vol. 74, no. 13, 29 March 1999 (1999-03-29), pages 1913-1915, XP000827172, ISSN: 0003-6951, DOI: 10.1063/1.123711

## Description

The invention relates to a method for providing a structural and/or a compositional modification in a molecular semiconductor target film by means of a thermal, a solvent vapour or a light stimulus that locally activates diffusion of functional molecules of a solution-deposited donor layer into the molecular semiconductor target film through a transitory interlayer.

Therefore, the present invention could be included in the field of manufacturing of electronic, optoelectronic and photonic devices and structures based on molecular semiconductor materials.

### BACKGROUND ART

Molecular semiconductors exhibit electronic and optical properties that originate from their specific chemical structure which may include, for instance in the case of organic (macro-)molecular semiconductors, π-conjugated (hetero)aromatic moieties. In a wide range of existing and emerging applications, molecular semiconductors are typically employed in the form of thin solid films with thicknesses ranging from a few nanometers to several micrometers (see, e.g., M. Eslamian, Nano-Micro Lett. 9, 3 (2017)). Vacuum-free large-area solution-based processing schemes are highly desirable for enabling energy- and cost-efficient fabrication, and are actively developed in the field.

Besides deposition of the molecular semiconductor layers, a key part of fabrication often requires local modification of the molecular material as part of a method for the fabrication of a wide range devices in order to enable device-specific functionalities, for instance:
- Local modification of material composition is required, for instance, for defining film regions of high electrical conductivity for electrodes and interconnects of thin-film transistors (TFTs) by local doping, or structuring emissive elements in light-emitting diodes (LEDs).
- Local modification of short-range molecular order is required in terms of the degree of crystallinity and, in the case of polymeric materials, chain conformation, with the aim of, for example, defining film regions exhibiting different charge-carrier mobility or refractive index.
- Local manipulation of long-range molecular order via (macro-)molecular orientation is sought for defining film regions exhibiting anisotropic optical, electronic, thermal and mechanical properties.

The state-of-art methods of solvent-enhanced dye diffusion in polymeric films are using a shadow mask, wherein the spatial resolution is determined by the shadow mask (F. Pschenitzka et al Materials Research Society Symposium Proceedings vol. 665. 31 December 2001 (2001-12-31) and F. Pschenitzka and J. C. Sturm, Appl. Phys. Lett., Vol. 74, No. 13, 29 March 1999). Therefore, a drawback of using shadow masks is that the spatial resolution is only about hundreds of microns. Furthermore, methods using a mask only provide two possible compositions in the target film: one in the covered areas, and a given composition in the places with openings. Additionally, accurate spatial alignment of the shadow mask with respect to the required location on the target film requires an additional processing step, which limits the overall process speed.

The state-of-the-art for local modification of material composition is photolithography (see, e.g., G. M. Wallraff et al., Chem. Rev. 99, 1801 (1999)). The typical processing steps may include (i) spin-coating of a photo-sensitive resist onto the target molecular semiconductor film, (ii) baking of the photoresist, (iii) exposing a desired spatial pattern on the photoresist, (iv) developing the photoresist, (v) performing the desired operation on the target layer and finally (vi) removing the residual photoresist. Despite offering spatial resolution down to micrometer scale, the disadvantages of photolithography include the above-described complex, multi-step processing which reduces throughput and, therewith, increases costs. Further drawbacks are related to the inherently additive- or subtractive-type modification which often necessitates subsequent backfilling to recover the planar film format for integration into devices, as well as the propensity for delamination of adjacent layers upon aging or flexure.

The state-of-the-art for local modification of short-range molecular order is dip-pen nanolithography (see, e.g., A. Perevedentsev et al., Nat. Commun. 6, 5977 (2015)). The typical process employs local deposition of solvent inks onto the target molecular semiconductor film via atomic force microscopy (AFM) tips. Despite offering spatial resolution down to micrometer scale, the disadvantages of dip-pen nanolithography include slow, typically micrometer per second, writing speeds, as well as the need for judicious control of tip-to-film separation for enabling ink deposition without simultaneous mechanical damage of the target film.

The state-of-the-art for local modification of long-range molecular order is mechanical rubbing (see, e.g., L. Hartmann et al., Adv. Funct. Mater. 21, 4047 (2011)). The typical process employs directional rubbing of the target molecular semiconductor film using a spinning wheel coated with a microfiber cloth. Despite offering rapid processing speeds, the disadvantages of mechanical rubbing include the propensity for mechanical damage of the target film, low spatial resolution (typically on the scale of several millimetres) and the inability to form complex patterns.

Therefore, it is needed to develop a new method for modifying structurally and/or compositionally molecular semiconductor layers.

### SUMMARY OF THE INVENTION

The problem to be solved by process of the invention is to provide a versatile method for the fabrication of a wide range devices and structures based on molecular materials, particularly molecular semiconductors. Particularly the process of the invention aims to provide a method for modifying structurally and/or compositionally a molecular semiconductor target film, aiming to modify properties/characteristics in the molecular semiconductor target film such as material composition, molecular orientation, chain conformation and crystallinity which are related to optical and electronic properties such as light absorption/emission, refractive index, electrical conductivity, etc.

Said method is of interest for the manufacturing of electronic and photonic devices and structures in the field of molecular electronics, such as waveguides, diffraction gratings, LEDs, TFTs, security elements for banknotes and personal ID, photodetectors, thermoelectric power generators, wearable electronics, etc, wherein the modified molecular semiconductor target film is suitable for being used as part of an electronic and/or a photonic device.

The first aspect of the invention refers to a method according to the claims for providing a structural and/or a compositional modification in a molecular semiconductor target film located onto a substrate, said method characterized in that it comprises the following steps:
a) depositing a semipermeable transitory interlayer onto the molecular semiconductor target film located onto a substrate by means of solution-based deposition techniques,
b) depositing a solid donor layer comprising a plurality of functional molecular additives onto the semipermeable transitory interlayer obtained in step (a) by means of solution-based deposition techniques,
c) exposing the structure obtained in step (b) to thermal, solvent vapour or light stimulus, and
d) chemical or physical removal of the solid donor layer and of the semipermeable transitory interlayer.

In the present invention the term "molecular semiconductor target film" refers herein to the target film which is intended to be modified by the method of the present invention. In the case of organic (macro-)molecular semiconductors there are two subclasses, namely: low-molecular-weight materials and polymers. Both have in common a conjugated π-electron system formed by the p_{z} orbitals of sp²-hybridized C atoms in the molecules. In comparison to the σ bonds constituting the backbone of the molecules, π bonding is significantly weaker. Therefore, the lowest electronic excitations of conjugated molecules are the π-π* transitions with an energy gap typically between 1.5 and 3 eV leading to light absorption or emission in the visible and near-infrared spectral range. Molecular semiconductors such as polymers can conduct electricity when doped or charge carriers are injected into them. Molecular semiconductors, having the electrical and optical properties of semiconductors and the mechanical properties of plastics, are good candidates for developing low-cost, flexible electronic, optoelectronic and photonic devices, for example transistors, LEDs, photodetectors, etc.

The term "compositional modification" refers to the change of the composition of the molecular semiconductor target film.

The term "structural modification" refers herein to the change of the conformation, the crystalline structure, the degree of crystallinity or the molecular orientation of the molecular semiconductor material target film.

In the present invention the structural and/or a compositional modification is performed by means of introducing functional molecular additives into the molecular semiconductor target film, wherein the term "functional" refers to the ability of said functional molecular additives to induce the desired structural and/or compositional modification by their specific physico-chemical interaction with the target molecular material. Said functional molecular additives should be soluble, have a melting temperature above 40 °C to form a solid donor layer and a molecular weight below about 1500 g/mol.
- Examples of said functional molecular additives are solvents, dyes, light-emitting dyes, nucleating agents, cross-linking agents, reactive monomers and catalysts. Preferably said additives have a molecular weight below about 1500 g/mol.
- Examples of said "bio" functional molecular additives are antigens, antibiotics, amino acids and oligopeptides. Preferably said additives have a molecular weight below about 1500 g/mol.
- Other functional molecular additives are electronic compounds such as fullerene or non-fullerene electron acceptors, and molecular dopants

The term "additive" implies that it is added to the target layer but not necessarily permanently. Depending on the specific structural and/or compositional modification required, the functional molecular additives may or may not be retained in the obtained modified molecular semiconductor target film. For example, in the case of structuring chain conformation and orientation, the functional molecular additives are subsequently removed by chemical means or by sublimation.

The term "donor layer" refers herein to a layer that comprises a plurality of functional molecular additives which are used for inducing the desired structural and/or the compositional modification in the molecular semiconductor. Preferred functional molecular additives of the donor layer are selected from solvents, dyes, light-emitting dyes, nucleating agents, cross-linking agents, reactive monomers, catalysts, antigens, antibiotics, amino acids, oligopeptides, molecular electron acceptors, molecular electron donors, molecular electrical dopants or a combination thereof. The term "semipermeable transitory interlayer" refers herein a layer that is placed between the molecular semiconductor target film and the donor layer. The transitory interlayer prevents diffusion of functional molecular additives into the target layer during deposition of the donor layer comprising said functional molecular additives. Therefore, the transitory interlayer should be substantially impermeable at the conditions (temperature and the kinetics of solidification of the donor layer) used for depositing the donor layer in order to substantially preserve the primary structural and/or compositional characteristics of the target layer. On the contrary, the transitory interlayer allows the diffusion of a plurality of functional molecular additives comprising the donor layer into the molecular semiconductor target film through it under application of an appropriate stimulus; therefore, the transitory interlayer should be substantially permeable under the application of said stimulus. Diffusion is enabled only under application of stimulus.

Therefore, the above mentioned functional molecular additives preferably have a molecular weight below about 1500 g/mol in order for a desired fraction of said functional molecular additives to diffuse through the semipermeable transitory layer within a time less than about 1 minute.

The composition of the semipermeable transitory interlayer is selected from a group of polymers that are insoluble in solvents used for solution-based deposition of the target molecular semiconductor layer and the donor layer. Hence, for typical molecular semiconductors and functional molecular additives that are preferentially soluble in aromatic (for example, toluene or chlorobenzene) and polar aprotic (for example, acetone or acetonitrile) solvents, the semipermeable transitory interlayer should be selected from a group of polymers preferentially soluble in polar protic solvents such as water or methanol. Examples of a semipermeable transitory interlayer include poly(sodium 4-styrenesulfonate), polyvinyl butyral and polyvinyl alcohol.

One advantage of the process of the present invention is that, due to the presence of the semipermeable transitory interlayer, the primary characteristics (such as photoluminescence spectrum or electrical conductivity) of the molecular semiconductor target film are not modified following solution-based deposition of transitory interlayer and donor layer. This enables subsequent controllable/local modification under application of stimulus. Without the semipermeable transitory interlayer, the structural and/or compositional characteristics of the molecular semiconductor target film are modified simultaneously with donor layer deposition, thereby preventing the possibility of subsequent local modification.

The function of the thermal, solvent vapour or light stimulus is to melt and/or dissolve the plurality of functional molecular additives of the donor layer and activate diffusion of a substantial fraction of said functional additives into the molecular semiconductor target film through the semipermeable transitory interlayer. Not all of the functional molecular additives are diffusing into the target layer, only a fraction.

Step (a) of the present invention refers to the deposition of a semipermeable transitory interlayer onto the molecular semiconductor target film located onto a substrate by means of solution-based deposition techniques. Preferably, the molecular semiconductor target film is deposited onto a substrate by means of solution-based deposition techniques, more preferably by means of spin-, blade-, spray- or slot-die coating techniques.

The molecular semiconductor target film precursor solution and the substrate may be preheated prior to deposition in step (a).

Step (b) of the present invention refers to the deposition of a solid donor layer onto the semipermeable transitory interlayer obtained in step (a) by means of solution-based deposition techniques. Preferably, step (b) is performed by spin-, blade-, spray- or slot-die coating techniques.

The deposition of the solid donor layer onto the semipermeable transitory interlayer in step b) does not change the primary characteristics of the molecular semiconductor target film. Preferably, when said characteristics are luminescence or material composition, the spectral position of maximum photoluminescence intensity does not change by more than 10 nm. Preferably, when said characteristic is electrical conductivity, its value does not change by more than a factor of 100.

Step (c) of the present invention refers to exposure of the structure obtained in step (b) to thermal, solvent vapour or light stimulus, thereby inducing a structural and/or a compositional modification in the molecular semiconductor target film.

As mentioned above, the function of the thermal, solvent vapour or light stimulus is to melt and/or dissolve the plurality of functional molecular additives of the donor layer and activate diffusion of a substantial fraction of said functional additives into the molecular semiconductor target film through the semipermeable transitory interlayer.

In a preferred embodiment of step (c), the structure obtained in step (b) is exposed to thermal, solvent vapour or light stimulus patternwise. For instance, said patternwise scanning (exposition) produces a directionality for the thermal gradient that produces molecular orientation.

In more preferred embodiment of step (c), the structure obtained in step (b) is exposed to a thermal stimulus, preferably by means of a hot plate, a hot tip, a hot stamp or a hot gas.

In another more preferred embodiment of step (c), the structure obtained in step (b) is exposed to a solvent-vapour stimulus, preferably by means of a nozzle or a slot-die. Said solvent is selected from a group of solvents which preferentially dissolve or swell the materials comprising the donor layer such as acetone or toluene.

In another more preferred embodiment of step (c), the structure obtained in step (b) is exposed to a light stimulus. For the conversion of the light stimulus into heat the presence of a light-absorbing layer is essential. Therefore, for this latter preferred embodiment of step (c), at least the substrate, the molecular semiconductor target film, the semipermeable transitory interlayer or the donor layer is a light-absorbing layer, or the substrate on which the molecular semiconductor target film is located comprises a light-absorbing layer. Preferred wavelengths for light stimulus are those in the ultraviolet to near-infrared spectral region which substantially match absorption of a given light-absorbing layer in order to enable light-to-heat conversion. Furthermore, the structure obtained in step (b) is exposed to a light stimulus preferably by means of a laser or a flash lamp. Pulsed or continuous-wave laser can be used. Furthermore, for the modification of local areas of the molecular semiconductor target film a shadow mask can be used. Moreover, patternwise scanning of local areas are also possible using lasers.

Step (d) of the present invention refers to the chemical or physical removal of the solid donor layer and of the semipermeable transitory interlayer. Chemical and/or physical removal of the solid donor layer and of the semipermeable transitory interlayer is performed without appreciable deterioration of the structural and/or compositional modification induced in the target molecular semiconductor layer.

Chemical removal of the solid donor layer and of the semipermeable transitory interlayer may be performed by exposure to solvents selected from a group of solvents which preferentially dissolve the materials comprising the donor layer (e.g. acetone or acetonitrile) and the transitory interlayer (e.g. water or methanol). Said solvents can be selected to be the same as those used for solution-based deposition of the transitory interlayer and donor layer in steps (a) and (b) respectively.

Physical removal of the solid donor layer and of the semipermeable transitory interlayer may be performed by imprinting and lift-off using a conformal-contact-forming stamp of, for instance, a polydimethylsiloxane (PDMS) elastomer.

Unless otherwise defined, all technical and scientific terms used herein have the same meaning as commonly understood by one of ordinary skill in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

### BRIEF DESCRIPTION OF THE DRAWINGS

FIG. 1. (A)-(E) are schematic sectional views of the principal steps for modifying a target layer using thermal stimulus, including corresponding fluorescence micrographs for an exemplary target film, the chain conformation and light-emission characteristics of which were modified using the same.
FIG. 2. (A)-(E) are schematic sectional views of the principal steps for modifying a target layer using solvent vapour, including corresponding fluorescence micrographs for an exemplary target film, the chain conformation and light-emission characteristics of which were modified using the same.
FIG. 3. (A)-(B) are schematic sectional views and corresponding fluorescence images illustrating modification of composition and light-emission characteristics of a target semiconducting polymer film using solvent vapour stimulus.
FIG. 4. (A)-(C) are schematic sectional view, and corresponding fluorescence image and photoluminescence spectra, of a target semiconducting polymer film with spatially-varying modification of composition and light-emission characteristics using solvent vapour stimulus.
FIG. 5. (A)-(C) are plots of electrical conductivity, optical micrographs and absorption spectra for a target semiconducting polymer film, the composition and electrical conductivity of which were modified using thermal stimulus.
FIG. 6. (A)-(C) are plots of electrical conductivity and optical micrographs for a target semiconducting polymer film, the composition and electrical conductivity of which were modified, assisted by a co-solvent, using thermal stimulus.
FIG. 7. (A)-(B) are schematic sectional views showing different means for exposing a sample to light stimulus.
FIG. 8. (A)-(D) are confocal photoluminescence microscopy and Raman intensity ratio images; photoluminescence spectra, and plots of pattern characteristics as function of processing parameters for target semiconducting polymer film, the chain conformation of which was locally modified using light stimulus.
FIG. 9. (A)-(F) are polarized optical micrographs; polarized Raman spectra; details of exemplary Raman anisotropy analysis, and plots of Raman anisotropy as function of processing parameters for a target semiconducting polymer film, the chain orientation of which was locally modified using light stimulus.
FIG. 10. (A)-(B) are large-area polarized optical micrographs of a target semiconducting polymer film, the chain orientation of which was locally modified using light stimulus.
FIG. 11. (A)-(C) are atomic force microscopy image and topography analysis for a target semiconducting polymer film, the chain orientation of which was locally modified using light stimulus.
FIG. 12 is an optical micrograph of a target semiconducting polymer film, the chain orientation of which was locally modified using a light-based stimulus without employing the transitory interlayer.
FIG. 13. (A)-(D) are optical micrograph and plot of electrical conductivity as function of processing parameters for a target semiconducting polymer film, the composition and electrical conductivity of which were modified using light stimulus; and reference Raman spectroscopy data as a function of electrical conductivity for target films of said polymer, the composition and electrical conductivity of which were modified using thermal stimulus.
FIG. 14. (A)-(C) are optical micrograph, Raman intensity ratio image and plot of electrical conductivity as a function of position for a target semiconducting polymer film, the composition and electrical conductivity of which were modified using light stimulus.
FIG. 15. (A)-(B) are optical micrographs and schematic sectional views for exemplary donor layers deposited from solution onto a transitory interlayer, and directly onto a target film, respectively.
FIG. 16. (A)-(B) are sectional views and optical micrographs showing the removal of a transitory interlayer by chemical and physical means.

### Examples

### Materials

The following compounds were purchased from Sigma-Aldrich:
"pNaSS": Poly(sodium 4-styrenesulfonate); MW ≈ 1,000,000 g/mol
"PFO": Poly(9,9-dioctylfluorene); MW ≥ 20,000 g/mol
"P3HT": Poly(3-hexylthiophene); MW~ 100,000 g/mol, regioregular
"PMMA": Poly(methyl methacrylate); MW ≈ 15,000 g/mol
"Coumarin 334": 10-Acetyl-2,3,6,7-tetra-hydro-1*H*,5*H*,11*H*-1-benzo-pyrano[6,7,8-*ij*]quinolizin-11-one (99%)
"Triton X-100": 4-(1,1,3,3-Tetramethylbutyl)phenyl-polyethylene glycol

The following compounds were purchased from TCI Chemicals
Lauric acid (>98%)
"BT": 2,1,3-benzothiadiazole (>99%)
"BCF": Tris(pentafluorophenyl)borane (>98%)
Biphenyl (>99.5%) "DCM": 4-(dicyanomethylne)-2-methyl-6-(4-dimethylaminostyryl)-4H-pyran (>95%)
L-(+)-mandelic acid (>99%)

The following compounds were purchased from 1-Material:
"PBTTT-C14": Poly(2,5-bis(3-tetradecylthiophen-2-yl)thieno-[3,2-b]thiophene); MW ≈ 50,000 g/mol

Standard laboratory-grade solvents (>99% purity) were used throughout.

**TABLE 1**

| Compound | Molar mass (g/mol) |
|---|---|
| 2,1,3-benzothiadiazole | 136.17 |
| biphenyl | 154.21 |
| lauric acid | 200.32 |
| Coumarin 334 | 283.32 |
| DCM | 303.37 |
| BCF | 511.98 |

### Techniques used for the characterisation

Film thickness was measured using a DektakXT profilometer (Bruker).

Electrical conductivity was measured with an Ecopia HMS-5000 instrument using the four-probe van der Pauw method for square ~6×6 mm² film areas with silver paste contacts placed on each corner.

Vis-NIR absorption spectra were recorded with a Bruker Vertex 70 FTIR spectrophotometer coupled to a Bruker Hyperion optical microscope.

Spectroscopic analysis of photoluminescence and Raman scattering was performed using a WITec Alpha 300RA instrument (reflection geometry; continuous-wave excitation used throughout). PL spectra were recorded with excitation at 355 nm or 365 nm (as indicated in the text). Raman spectra were recorded with excitation at 488 nm (PBTTT-C14 films), 633 nm (PFO films) and 785 nm (P3HT films). Polarised Raman analysis was performed with synchronous adjustment of both excitation and detection polarisation.

Atomic force microscopy was performed in tapping mode with a Keysight 5500 instrument (Agilent).

All characterisation was carried out in ambient atmosphere at room temperature.

### Example 1: Modification of chain conformation and light-emission characteristics of a PFO target film (2) by means of thermal stimulus.

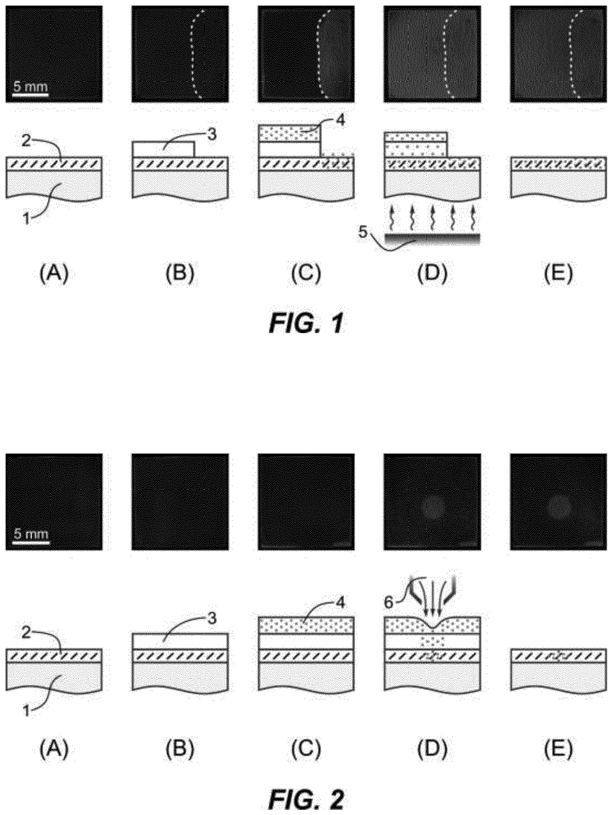

Schematic illustrations of the individual processing steps and the corresponding optical micrographs recorded under UV light illumination using a wavelength of 365 nm are shown in Fig. 1.
(1) Substrate
(2) Molecular semiconductor target film
(3) Semipermeable transitory interlayer
(4) Donor layer
(5) Hotplate

Onto a glass substrate (1) a glassy, in-plane isotropic PFO target film (2) (thickness approximately 85 nm) was spin-coated from a 2 wt% solution in toluene at 2000 rpm, with both solution and substrate (1) pre-heated to 70 °C prior to deposition. See Fig. 1(A).

pNaSS transitory interlayer (3) was then spin-coated from a 4 wt% solution in water, additionally containing about 1 wt% of Triton X-100 surfactant added relative to the amount of solvent, at 3000 rpm (thickness approximately 200 nm).

Fig. 1(B) shows that the transitory interlayer (3) is easy to remove by immersion in water without changing light-emission colour of the PFO target film (2).

Lauric acid donor layer (4) was then spin-coated from a 20 wt% solution in acetone at 8000 rpm.

Fig. 1(C) shows that in the region without transitory interlayer (3) light-emission colour is changed due to diffusion of lauric acid into the PFO layer target film (2) taking place during deposition and, therewith, the formation of the so-called 'β-phase' conformation in the PFO target film (2).

On the contrary, PFO target film (2) retains its original chain conformation and light-emission characteristics in the region where the pNaSS transitory interlayer (3) is present, as depicted in Fig. 1(C).

Afterwards, the sample was placed on a hotplate (5) at 50 °C (*N.B.* melting temperature of lauric acid = 44 °C) for 1 min, activating the diffusion of lauric acid into the PFO target film (2) and resulting in a concomitant colour change of light emission from purple/dark-blue ('glassy' PFO; appearing in Fig. 1(A)-(C) as dark-grey) to light-blue ('β-phase' PFO - appearing in Fig. 1(C)-(E) as light-grey). PFO deposited from heated solutions (as in this Example) features chains in a range of disordered, 'worm-like' conformations - collectively termed 'glassy'. Subsequent exposure of glassy PFO to solvents leads to a fraction of chain segments adopting the 'β-phase' conformation - a distinct, chain-extended molecular geometry with co-planar orientation of adjacent repeat units. The presence of the planarised β-phase conformation is manifested in red-shifted absorption and photoluminescence (PL) spectra; specifically, maximum PL intensity of β-phase PFO is at 438 nm (light-blue) compared with 423 nm (purple/dark-blue) for glassy PFO.

In this Example, therefore, exposure of the PFO target film (2) to the lauric acid donor compound (4) by its thermally-activated diffusion via the transitory interlayer (3) modifies chain conformation of a fraction of PFO chain segments from glassy to β-phase, yielding the aforementioned changes in light-emission characteristics.

The residual lauric acid donor layer (4) and the pNaSS transitory interlayer (3) were then removed from the sample by spinning the sample at 5000 rpm and depositing, sequentially, 50 µL of acetone, 50 µL of water, and a further 50 µL of acetone. Characteristics induced in the PFO target film (2) are not affected by this chemical process. Fig. 1(E) shows homogeneity of light-emission colour of the obtained PFO target film (2) in the region where the pNaSS transitory interlayer (3) was present. On the contrary, homogeneity of light-emission colour is visibly much worse in the region where the interlayer was not present.

### Example 2: Modification of chain conformation and light-emission characteristics of a PFO target film (2) by means of solvent vapour stimulus.

Schematic illustrations of the individual processing steps and the corresponding optical micrographs recorded under UV light illumination using a wavelength of 365 nm are shown in Fig. 2.
(1) Substrate
(2) Molecular semiconductor target film
(3) Semipermeable transitory interlayer
(4) Donor layer
(6) Nozzle

Onto a glass substrate (1) a PFO target film (2), pNaSS transitory interlayer (3) and lauric acid donor layer (4) were deposited as described in Example 1; see Fig. 2(A)-(C).

Afterwards, solvent vapour of 1:1 vol/vol acetone:water was generated by bubbling nitrogen carrier gas through a two-terminal vessel containing said solution, and directed to the sample via a 2 mm diameter nozzle (6) placed about 5 mm above sample surface. The solvent-vapour-activated diffusion of lauric acid donor compound (4) into the PFO target film (2) modifies the corresponding chain conformation from glassy to β-phase and, thereby, induces a change in the light-emission characteristics (Fig. 2(D)).

The residual lauric acid donor layer (4) and the pNaSS transitory interlayer (3) were then removed from the sample by spinning the sample at 5000 rpm and depositing, sequentially, 50 µL of acetone, 50 µL of water, and a further 50 µL of acetone. Characteristics induced in the PFO target film (2) are not affected by this chemical process. Fig. 2(E) shows that the obtained PFO target film (2) comprises a local β-phase PFO area surrounded by glassy PFO .

### Example 3: Modification of composition and light-emission characteristics of a PFO target film (2) by means of solvent vapour stimulus.

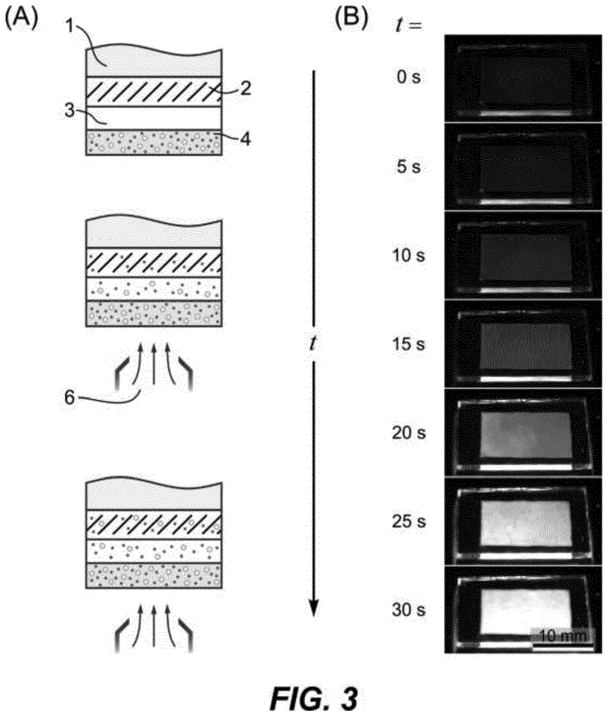

As shown in Fig. 3(A), onto a glass substrate (1) a PFO target film (2) and pNaSS transitory interlayer (3) were deposited as described in Example 1.
(1) Substrate
(2) Molecular semiconductor target film
(3) Semipermeable transitory interlayer
(4) Donor layer
(6) Nozzle

The donor layer (4) was then spin-coated from
- a 2 wt% Coumarin 334 (C₁₇H₁₇NO₃; cyan-emitting Dye 1) solution in 1:2 wt/wt acetone:methylene choride
- which further comprises 1 wt% DCM (C₁₉H₁₇N₃O; orange-emitting Dye 2), 1 wt% mandelic acid (solid solvent; melting temperature = 135 °C), and 4 wt% PMMA added relative to the amount of solvent-at 6000 rpm

Accordingly, the solid donor layer (4) comprises a solid solution of Coumarin 334, DCM and mandelic acid embedded in an inert PMMA matrix.

Light-emission of the obtained sample, viewed under illumination at a wavelength of 365 nm through the substrate (1), is dark-blue and essentially corresponds to that of glassy PFO target film (2) (see image at 0 s in Fig. 3(B)). Light-emission of the dyes comprising the donor layer (4) is not apparent here due to concentration-induced quenching.

Afterwards, solvent vapour of 1:1 vol/vol acetone:water was generated by bubbling nitrogen carrier gas through a two-terminal vessel containing said solution, and directed to the sample via an 8 mm diameter nozzle (6) placed about 20 mm above sample surface.

The lower molar mass Coumarin 334 dye (Dye 1) diffuses into the PFO target film (2) faster than the higher molar mass DCM dye (Dye 2).

Accordingly, light-emission changes from dark-blue to cyan due to the presence of Dye 1 in the PFO target film (2), as shown in Fig. 3(B) in grey for images recorded 10-15 s after solvent vapour was applied.

Upon continued exposure to solvent vapour, the higher molar mass DCM dye (Dye 2) diffuses into the PFO target film (2). Accordingly, light-emission changes from cyan to orange due to the presence of Dye 2 in the PFO target film (2), as shown in grey in Fig. 3(B) for cyan and white in Fig. 3(B) for orange for images recorded 25-30 s after solvent vapour was applied.

### Example 4: Spatially-varying modification of composition and light-emission characteristics of a PFO target film (2) by means of solvent vapour stimulus.

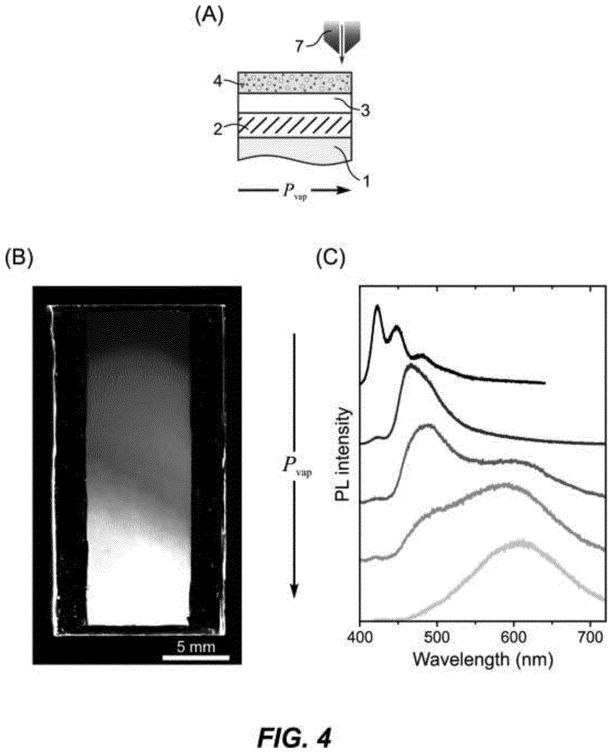

As shown in Fig. 4(A), onto a glass substrate (1) a PFO target film (2), pNaSS transitory interlayer (3), and a donor layer (4) comprising a solid solution of Coumarin 334 (Dye 1), DCM (Dye 2) and mandelic acid embedded in an inert PMMA matrix was deposited by spin-coating as described in Example 3.
(1) Substrate
(2) Molecular semiconductor target film
(3) Semipermeable transitory interlayer
(4) Donor layer
(7) Slot-die

Afterwards, solvent vapour of 1:1 vol/vol acetone:water was generated by bubbling nitrogen carrier gas through a two-terminal vessel containing said solution and directed to the sample via a slot-die (7) placed at the lower end of the substrate (1).

Fig. 4(B) shows an image of the sample recorded under illumination at a wavelength of 365 nm after the removal of the residual donor layer (4) by spinning the sample at 5000 rpm and depositing 50 µL of methylene chloride.

As determined by the placement of the slot-die (7), the relative solvent vapour pressure *P*ᵥₐₚ (that is, the ratio of solvent vapour pressure at a given location on the sample and that of the saturated stream) varied across the sample, increasing from top to bottom. Accordingly, light-emission of the sample varies, from top to bottom, from dark-blue to cyan and orange. This is further confirmed by the photoluminescence (PL) spectra recorded at spatial locations spanning the sample length from top to bottom (Fig. 4(C)).

### Example 5: Modification of composition and electrical conductivity of a PBTTT-C14 target film (2) by means of thermal stimulus.

Onto a glass substrate (1), a PBTTT-C14 target film (2) (thickness approximately 43 nm) was spin-coated from a 1.5 wt% solution in chlorobenzene at 4000 rpm, with both solution and substrate (1) pre-heated to 110 °C prior to deposition.

In order to avoid any temperature-dependent changes in polymer crystallinity accompanying subsequent application of thermal stimulus, the resulting film (2) was then crystallised by annealing at 180 °C under nitrogen atmosphere followed by slow cooling to room temperature.

pNaSS transitory interlayer (3) was then spin-coated from a 2 wt% solution in water, additionally containing about 1 wt% of Triton X-100 surfactant added relative to the amount of solvent, at 6000 rpm (thickness approximately 80 nm).

Donor layer (4) comprising the electrical p-type dopant BCF (B(C₆F₅)₃) was then spin-coated from a 60 wt% BCF solution in 10:1 wt/wt diethyl ether:methanol at 6000 rpm.

Thermal stimulus: sample was then thermally annealed in air for 1 min at a selected temperature in the 50 ºC to 120 °C range to activate diffusion of the dopant BCF from the donor layer (4) into the PBTTT-C14 target film (2).

The residual BCF donor layer (4) and pNaSS transitory interlayer (3) were then removed by spinning the sample at 5000 rpm and depositing, sequentially, 100 µL of acetonitrile and 100 µL of water.

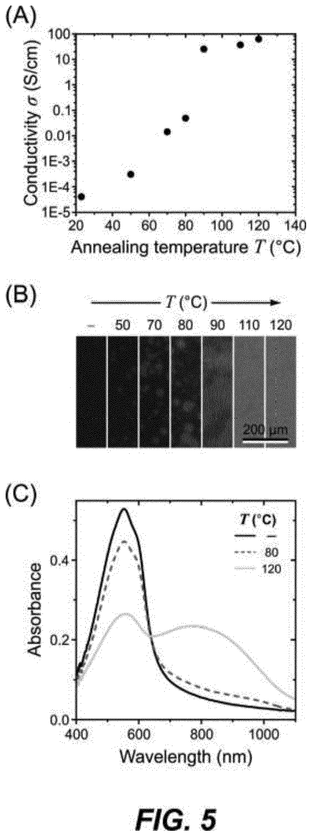

Electrical conductivity is induced in the PBTTT-C14 target film (2). Fig. 5(A) shows the electrical conductivity induced in the PBTTT-C14 target film (2) versus annealing temperature used as thermal stimulus, wherein conductivity is plotted on a semi-logarithmic scale and follows a sigmoidal profile, reaching a high value of 62 S/cm. Note also that, if thermal stimulus is not applied, PBTTT-C14 target film (2) retains its low conductivity of approximately 4×10⁻⁵ S/cm ("23 °C" data point in Fig. 5(A)).

Transmitted-light micrographs of the obtained PBTTT-C14 target film (2) following application of thermal stimulus by annealing at the different temperatures T are shown in Fig. 5(B) highlighting the improved homogeneity of doping at the higher annealing temperature. Note that employing annealing temperatures T higher than the melting temperature of BCF dopant of the donor layer (4) (126-131 °C) would lead to de-doping of PBTTT-C14 target film (2) by evaporation of dopant BCF of the donor layer (4) and, therewith, reduction of the obtained electrical conductivity.

Absorption spectra of the PBTTT-C14 target film (2) without application of thermal stimulus, and following application of thermal stimulus by annealing at 80 °C and 120 °C respectively, are shown in Fig. 5(C). Doping is confirmed (when thermal annealing is performed at 80 °C and 120 °C respectively) by the expected attenuation of neutral polymer absorption (centred at about 550 nm), and the simultaneous presence of a broad band corresponding to ionised species (centred at about 780 nm).

### Example 6: Modification of composition and electrical conductivity of a PBTTT-C14 target film (2) by means of thermal stimulus.

Onto glass substrates (1), a PBTTT-C14 target film (2) was deposited as described in Example 5.

In order to avoid any temperature-dependent changes in polymer crystallinity accompanying subsequent application of thermal stimulus, the resulting film (2) was then crystallised by annealing at 180 °C under nitrogen atmosphere followed by slow cooling to room temperature.

pNaSS transitory interlayer (3) was then deposited as described in Example 5.

Donor layer (4) comprises BCF:biphenyl: spin-coated from a 60 wt% BCF solution in 10:1 wt/wt diethyl ether:methanol which further comprises 5 wt% biphenyl added relative to the amount of solvent-at 6000 rpm. Biphenyl ("BP"; melting temperature = 69 °C) is employed as a co-solvent of BCF to reduce annealing temperature or annealing time required for obtaining a given electrical conductivity.

Thermal stimulus: samples were then thermally annealed in air (as described below) to activate diffusion of BCF into the PBTTT-C14 target film (2).

The residual BCF:biphenyl donor layer (4) and pNaSS transitory interlayer (3) were then removed by spinning the sample at 5000 rpm and depositing, sequentially, 100 µL of acetonitrile and 100 µL of water

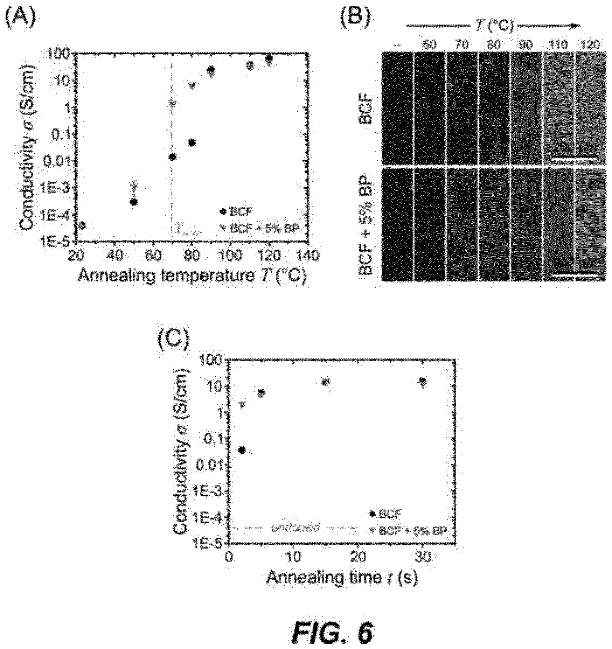

Electrical conductivity of samples obtained following application of thermal stimulus by thermal annealing for 1 min at temperatures ranging from 50 to 120 °C is shown in Fig. 6(A). For annealing temperatures equal to, or slightly above, the melting temperature of biphenyl (BP), the presence of biphenyl (BP) in the donor layer (4) enables an increase of electrical conductivity by about two orders of magnitude relative to samples wherein the donor layer (4) comprised only BCF. The corresponding transmitted-light micrographs (Fig. 6(B)) show the concomitantly improved homogeneity of doping for a given temperature (see data for "80 °C" and "90 °C" samples).

Electrical conductivity of samples obtained following application of thermal stimulus by thermal annealing at 100 °C for annealing time ranging from 2 to 30 s is shown in Fig. 6(C). For annealing time of 2 s, the presence of biphenyl (BP) in the donor layer (4) enables an increase of electrical conductivity by more than an order of magnitude relative to sample wherein the donor layer (4) comprised only BCF.

### Example 7: Modification of chain conformation of a PFO target film (2) by means of light stimulus.

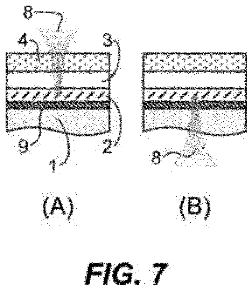

Onto an ITO layer (9) / glass substrate (1) a PFO target film (2), pNaSS transitory interlayer (3) and lauric acid donor layer (4) were deposited as described in Example 1; see Fig. 7(A).
(1) Substrate
(2) Molecular semiconductor target film
(3) Semipermeable transitory interlayer
(4) Donor layer
(8) Laser (Wavelength = 785 nm)
(9) Light-absorbing layer

Afterwards, the output of a 785 nm laser (8) was directed at the sample through the substrate (1) and focused on the PFO layer target film (2), as shown in Fig. 7(B). Here absorption of laser light occurs primarily within ITO layer (9), therewith generating heat primarily at the interface between substrate (1) and target film (2). Note that target layer (2), transitory interlayer (3) and donor layer (4) do not absorb 785 nm wavelength light to an appreciable degree. Laser power P was adjusted in the 10-50 mW range. The sample was continuously scanned in the focal plane of the laser (8) at speed *v* in the 0.1-10 µm/s range. The role of laser irradiation herein is to provide local heat by light absorption within ITO, activating local diffusion of lauric acid solvent from the lauric acid donor layer (4) into the PFO target layer (2), modifying its chain conformation.

The residual lauric acid donor layer (4) and the pNaSS transitory interlayer (3) were then removed from the sample by spinning the sample at 5000 rpm and depositing, sequentially, 50 µL of acetone, 50 µL of water, and a further 50 µL of acetone.

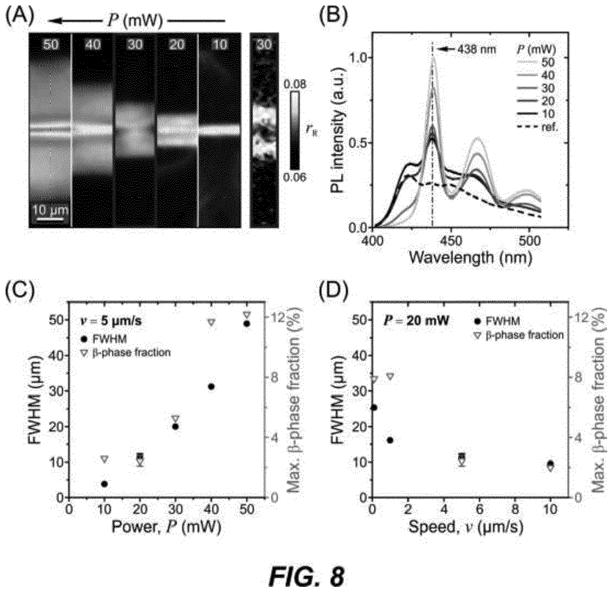

A modification of chain conformation is induced in the obtained samples. Confocal PL microscopy images recorded with excitation at 355 nm for continuous lines written at the indicated laser powers (*P* = 10-50 mW) and constant speed *v* = 5 µm/s are shown in Fig. 8(A), left panel, wherein spectral filtering at 438 nm was used to preferentially select the maximum of β-phase PFO PL emission, as shown in Fig. 8(B). Bright regions in Fig. 8(A) therefore correspond to sample areas for which the conformation of a fraction of chain segments was modified from glassy to β-phase.

PL spectra recorded at the centres of written lines (solid lines in Fig. 8(B)) corroborate formation of the β-phase conformation, exhibiting the characteristic vibronic peaks at 438 nm, 467 nm and 498 nm. On the contrary, the reference PL spectrum recorded outside the laser-exposed sample regions corresponds to that of pristine glassy PFO (dashed line in Fig. 8(B)), exhibiting vibronic peaks at 423 nm and 449 nm. Furthermore, the spectra show that the above-described laser-based process does not induce any appreciable photo-oxidative degradation of PFO target film (2), which would be evidenced by pronounced PL emerging at wavelengths above 500 nm.

Dimensions of regions with modified chain conformation were estimated as the full-width at half-maximum (FWHM) of PL intensity profiles at 438 nm across written lines. Contrast of the modified regions (that is, the maximum induced volume fraction of β-phase chain segments) was estimated by means of calibration of Raman intensity ratio *r*_{R} (1257 cm⁻¹ : 1606 cm⁻¹) versus β-phase fraction. *r*_{R}, and the corresponding β-phase fraction, were determined by spectroscopic Raman mapping of modified regions using excitation at 633 nm, with exemplary *r*_{R} image for a continuous line written at *v* = 5 µm/s and P = 30 mW shown in Fig. 8(A), right panel.

Dimensions and contrast of sample regions with modified chain conformation show a correlated evolution with incident laser power (Fig. 8(C)) and writing speed (Fig. 8(D)), enabling a straightforward means for obtaining the desired characteristics of modified regions. For instance, adjustment of P from 50 to 10 mW for constant *v* = 5 µm/s enables a 10- and 6-fold reduction of, respectively, the dimensions and contrast of modified regions.

### Example 8: Modification of chain orientation of a P3HT target film (2) by means of light stimulus.

Onto an ITO layer (9) / glass substrate (1) a P3HT target film (2) (thickness approximately 90 nm) was spin-coated from a 2 wt% solution in chlorobenzene at 4000 rpm, with both solution and ITO layer (9) / glass substrate (1) pre-heated to 50 °C prior to deposition; see Fig. 7(A).

pNaSS transitory interlayer (3) was then spin-coated from a 4 wt% solution in water, additionally containing about 1 wt% of Triton X-100 surfactant added relative to the amount of solvent, at 7000 rpm (thickness approximately 130 nm).

2,1,3-benzothiadiazole (BT) donor layer (4) was then deposited by spin-coating a 40 wt% solution in methylene chloride at 700 rpm and, following substantial solvent evaporation after about 60 s, placing a glass coverslip (0.17 mm thickness) onto the still-liquid BT donor layer (4). The accompanying nucleation and crystallization of BT yielded the desired solid BT donor layer (4) under a glass coverslip. Although not essential for the process, employing the glass coverslip prevents excessively rapid sublimation of BT during subsequent laser-based modification and improves homogeneity of the obtained donor layer (4) in terms of film thickness.

BT is selected as the donor layer (4) due to comparable periodicity of crystalline BT along its fast growth axis *c* with that of crystalline P3HT (*c*_{BT} = 3.85 Å; *c*_{P3HT}/2 ≈ 3.8 Å), enabling directional orientation of P3HT by epitaxial crystallization. A further condition for the latter is that crystallization of BT occurs prior to that of P3HT which is readily accomplished for hypoeutectic BT:P3HT compositions. BT as the donor layer (4) is additionally selected herein due to its low melting temperature (44 °C), which reduces the required processing temperatures.

Afterwards, the output of a 785 nm laser (8) was directed at the sample through the substrate (1) and focused on the P3HT layer target film (2), as shown in Fig. 7(B). Here absorption of laser light occurs primarily within ITO layer (9), therewith generating heat primarily at the interface between substrate (1) and target film (2). In this example, target layer (2), transitory interlayer (3) and donor layer (4) do not absorb 785 nm wavelength light to an appreciable degree. Constant laser power *P* = 55 mW was used. The sample was continuously scanned in the focal plane of the laser (8) at speed *v* in the 0.1-3 mm/s range.

The glass coverslip used in this example was then detached, allowing for rapid removal of the residual BT donor layer (4) by sublimation at ambient conditions. The pNaSS transitory interlayer (3) was then removed from the sample by spinning the sample at 5000 rpm and depositing 50 µL of water.

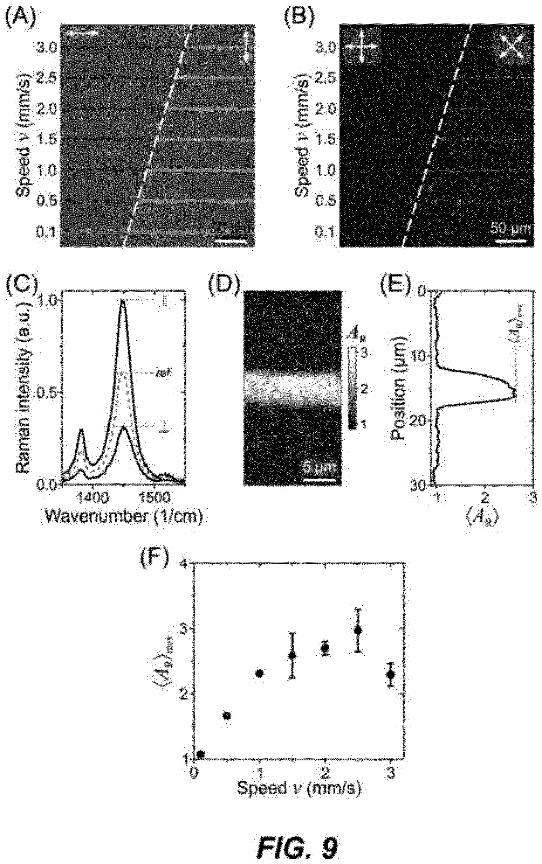

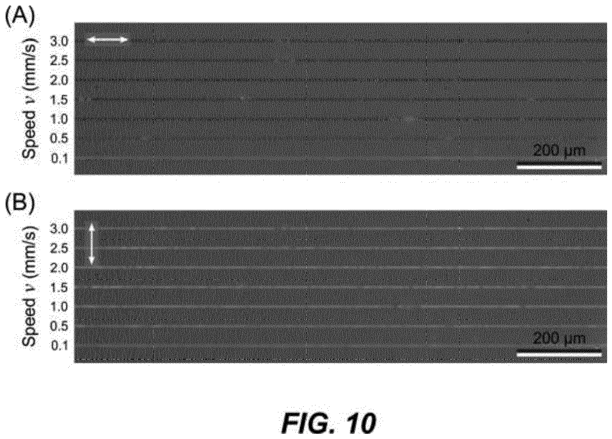

Optical anisotropy is induced in the obtained samples. Polarised transmitted-light micrographs (Fig. 9(A)) show that lines written at *v* ≥ 0.5 mm/s exhibit optical anisotropy, that is: appearing darker or lighter for transmitted light polarised, respectively, parallel or perpendicular to the laser scanning direction (left and right sides of Fig. 10(A) respectively; polarization directions are indicated by the arrows). Additional large-area polarised transmitted-light micrographs shown Fig. 10(A)-(B) (transmitted light polarised, respectively, parallel and perpendicular to the laser scanning direction, as indicated by the arrows) highlight the homogeneity of modified regions. This dependency of absorbance on the direction of light polarization indicates preferential orientation of P3HT chain segments parallel to the laser scanning direction. The latter is further corroborated by cross-polarized micrographs for the same sample area (Fig. 9(B); polarization directions are indicated) which show that birefringence for the modified regions is only visualized for light polarized at an angle to the laser scanning direction (Fig. 9(B), right panel).

Therefore, the role of laser irradiation herein is to provide local heat by light absorption within ITO, activating local diffusion of the BT solvent from the BT donor layer (4) into the P3HT target layer (2) and dissolving the latter. Subsequent removal of light-induced heat (that is, by scanning the laser away from a given sample area) results in crystallisation of BT within the P3HT:BT layer (2) and, therewith, directional crystallisation of P3HT. Hence, a local modification of chain orientation of the P3HT target layer (2) is obtained.

Polarized Raman spectroscopy analysis is used to quantify the degree of molecular anisotropy (that is, chain orientation) for the modified regions. Exemplary polarized Raman spectra recorded using excitation at 785 nm at the centre of the line written using *v* = 2.5 mm/s and *P* = 55 mW (solid lines; Fig. 9(C)) show higher intensity of the symmetric C=C stretching mode of P3HT at about 1450 cm⁻¹ for polarization parallel to the laser scanning direction. This indicates preferential orientation of P3HT chain segments parallel to the laser scanning direction. A reference spectrum recorded outside the modified region is also shown (dotted line; Fig. 9(C)).

Raman anisotropy, *A*_{R}, was thus defined as the ratio of maximum intensities for said vibrational mode of P3HT recorded with polarization parallel and perpendicular to the laser scanning direction. Polarized spectroscopic Raman mapping was used to quantify molecular anisotropy and its spatial distribution for the modified regions. An exemplary image of *A*_{R} for a line written using *v* = 2 mm/s and *P* = 55 mW is shown in Fig. 9(D). The corresponding profiles of average Raman anisotropy, 〈*A*_{R}〉, were obtained by averaging the *A*_{R} images along the laser scanning direction. An exemplary 〈*A*_{R}〉 profile obtained for the *A*_{R} image in Fig. 9(D) is shown in Fig. 9(E), wherein 〈*A*_{R}〉 increases to about 2.6, indicating preferential orientation of P3HT chain segments within the target film (2) parallel to the laser scanning direction in the laser-irradiated region. FWHM dimensions of regions with modified chain orientation estimated from 〈*A*_{R}〉 profiles are 4.6 ± 0.3 µm for lines written at *v* ranging from 0.5 to 3 mm/s.

Fig. 9(E) also shows that 〈*A*_{R}〉 = 1 for sample regions not exposed to light stimulus, indicating that chain orientation remains in-plane isotropic as in the original P3HT target film (2) (consistent with polarised optical micrographs shown in Fig. 9(A)-(B)). This confirms that in the absence of an applied stimulus, such as the laser irradiation used herein, the transitory interlayer (3) prevents diffusion of BT comprising the donor layer (4) into the P3HT target film (2), thereby preserving its original microstructure.

Maximum obtained 〈*A*_{R}〉 values (〈*A*_{R}〉ₘₐₓ; as indicated in Fig. 9(E)) as a function of writing speed *v* are shown in Fig. 9(F), indicating that rapid modification of chain orientation can be achieved with laser scanning speeds in the mm/s range. 〈*A*_{R}〉ₘₐₓ increases with *v* up to a value of about 3 for *v* = 2.5 mm/s. At lower speeds (e.g. 0.1 mm/s; see Fig. 9(F)) laser-induced overheating leads to depletion of BT from the exposed regions and, hence, a reduction of 〈*A*_{R}〉ₘₐₓ. At higher speeds (e.g. 3 mm/s; see Fig. 9(F)) 〈*A*_{R}〉ₘₐₓ reduces due to an insufficient temperature rise and/or diffusion of an insufficient amount of BT via the transitory interlayer (3) into the P3HT target film (2). Higher writing speeds may be used without compromising the degree of chain orientation following optimisation of the multilayer architecture in terms of, for instance, thickness of the transitory interlayer (3), as well as the employing higher laser power.

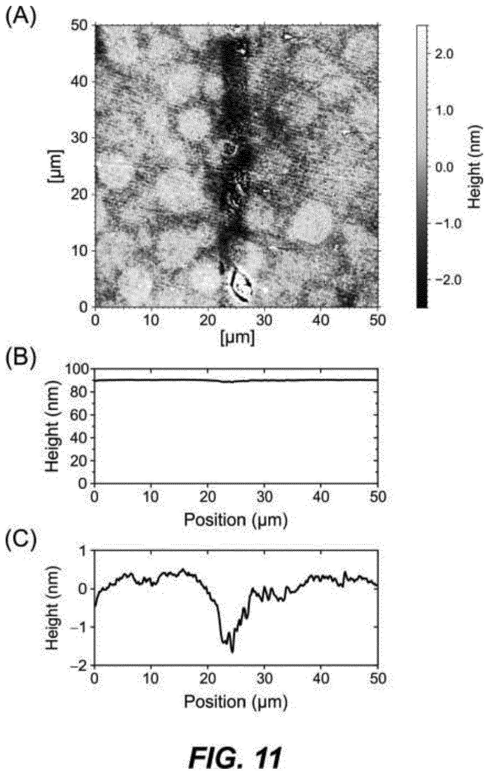

Exemplary analysis of film topography by atomic force microscopy (AFM) is shown in Fig. 11(A) for a line written using *v* = 2.5 mm/s and *P* = 55 mW. The corresponding film thickness profile (Fig. 11(B)) reveals only a 2% reduction of film thickness for the modified region, an expanded view of which is shown in Fig. 11(C). This indicates that planarity of the obtained P3HT target film (2) with regions of modified chain orientation is preserved due to confinement by the transitory interlayer (3). Preserving film planarity offers a significant advantage for integration of such samples within electronic, optoelectronic and photonic devices. By comparison, P3HT films macroscopically oriented using crystallisable small-molecular compounds similar to BT without the use of a transitory interlayer typically exhibit root-mean-square (RMS) surface roughness up to 30 nm and, in some cases, exceeding 100 nm.

Comparative example: Modification of chain orientation of a P3HT target film (2) by means of light stimulus without employing the transitory interlayer (3).

In this comparative example, laser-based modification of chain orientation for a P3HT target film (2) was performed without the use of the transitory interlayer. Onto an ITO (9) / glass substrate (1) a P3HT target film (2) was deposited as described in Example 8. BT donor layer (4) was then deposited as described in Example 8.

Afterwards, the output of a 532 nm laser (8) was directed at the sample through the substrate (1) and focused about 25 µm above the P3HT target film (2) to increase the resultant width of modified regions. Here absorption of laser light occurs primarily within the target layer (2) given that laser excitation at 532 nm closely matches the spectral position of absorption maximum of P3HT. Hence, heat is generated primarily within the P3HT target film (2). Constant laser power *P* = 10 mW was used. The sample was continuously scanned in the focal plane of the laser (8) at speed *v* = 3 mm/s.

The BT donor layer (4) was then removed by sublimation as described in Example 8.

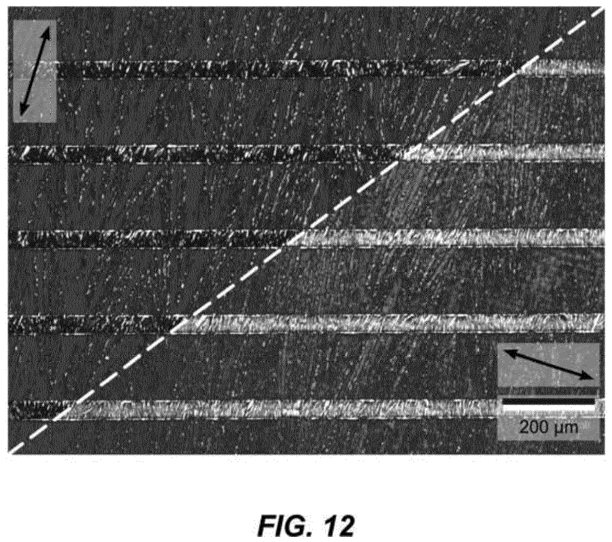

Polarised transmitted-light micrographs (Fig. 12; polarization directions are indicated by the arrows) highlight a number of disadvantages of modifying chain orientation without the use of a transitory interlayer. First, although some degree of chain orientation is induced for the lines-as shown by the polarization-dependent differences in brightness (that is, absorbance) for the modified regions-the direction of orientation is evidently not correlated with the laser scanning direction, with an average angle of about 70° between the two. This results from the BT donor layer (4) herein being in direct contact with the P3HT target film (2). Hence, although laser-induced heating stimulates the required diffusion of BT into the P3HT target film (2) and dissolution of the latter, upon removal of heat the direction of crystallisation of BT within the P3HT:BT layer (2) is instead dictated by that of the crystalline BT of the donor layer (4) outside laser-irradiated sample regions. Given that it is extremely difficult to accurately control the crystal orientation of a BT donor layer (4) deposited from solution, controllable and reproducible modification of chain orientation of target film (2) parallel to the laser scanning direction is prevented in the absence of a transitory interlayer (3).

Second, the obtained P3HT target film (2) exhibits a pronounced fibrillar texture outside the laser-irradiated regions (see Fig. 12; sample regions between lines). This indicates that the original P3HT target film (2) is irreversibly modified by the deposition of the BT donor layer (4) directly onto the P3HT target layer (2) and, therewith, (partial) dissolution and directional crystallisation of the latter. Further examination of the polarised optical micrographs in Fig. 12 reveals different, polarisation-dependent brightness (that is, absorbance) for sample regions not exposed to the light stimulus. This confirms (partial) orientation of the P3HT target film (2) prior to application of any stimulus. Hence, the use of the transitory interlayer offers clear advantages for enabling modification of chain orientation of a polymer target layer (2) within selective regions determined by, in this example, laser irradiation.

### Example 9: Modification of composition and electrical conductivity of a PBTTT-C14 target film (2) by means of light stimulus.

Onto a glass substrate (1), a PBTTT-C14 target film (2) (thickness approximately 43 nm) was spin-coated from a 1.5 wt% solution in chlorobenzene at 4000 rpm, with both solution and substrate (1) pre-heated to 110 °C prior to deposition.

In order to avoid any temperature-dependent changes in polymer crystallinity accompanying subsequent application of thermal stimulus, the resulting film (2) was then crystallised by annealing at 180 °C under nitrogen atmosphere followed by slow cooling to room temperature.

pNaSS transitory interlayer (3) was then spin-coated from a 2 wt% solution in water, additionally containing about 1 wt% of Triton X-100 surfactant added relative to the amount of solvent, at 6000 rpm (thickness approximately 80 nm).

Donor layer (4) comprising BCF was then spin-coated from a 60 wt% BCF solution in 10:1 wt/wt diethyl ether:methanol at 9000 rpm.

Afterwards, the output of a 532 nm laser (8) was directed at the sample through the donor layer (4), as shown in Fig. 7(A), and focused about 20 µm above the PBTTT-C14 target film (2) to increase the resultant width of modified regions. Here absorption of laser light occurs primarily within the target layer (2) given that the laser excitation at 532 nm closely matches the spectral position of absorption maximum of PBTTT-C14 target film (2). Hence, the role of laser irradiation herein is to provide local heat by light absorption within the PBTTT-C14 target film (2), activating local diffusion of the BCF dopant from the donor layer (4) into the PBTTT-C14 target film (2) and doping the latter. Laser power P was adjusted in the 5-10 mW range. The sample was continuously scanned in the focal plane of the laser (8) at speed *v* ranging from 5 µm/s to 3 mm/s.

The residual BCF donor layer (4) and pNaSS transitory interlayer (3) were then removed by spinning the sample at 5000 rpm and depositing, sequentially, 100 µL of acetonitrile and 100 µL of water.

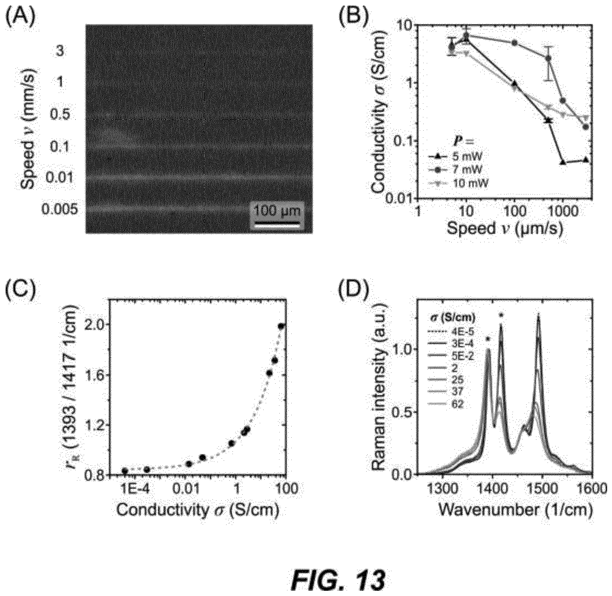

Transmitted-light micrographs (Fig. 13(A)) show the lighter appearance of written lines compared with the pristine film which, given the above-mentioned attenuation of neutral PBTTT-C14 absorption upon doping, indicates that electrical conductivity has been induced in the modified regions. Hence, Fig. 13(A) shows that the use of light stimulus enables local modification of electrical conductivity of PBTTT-C14 target film (2) on micrometer scale, compared with similar modification on larger, millimetre scale obtained with thermal stimulus in Examples 5 and 6. Local, micrometer-scale modification of electrical conductivity is required for a range of electronic devices, including thin film transistors and other optoelectronic devices.

Quantitative analysis of maximum electrical conductivity induced by means of light stimulus as a function of writing speed *v* and laser power P is shown in Fig. 13(B). Here local conductivity values were estimated by means of experimentally obtained calibration data of Raman intensity ratio *r*_{R} (1393 cm⁻¹ : 1417 cm⁻¹; recorded with excitation at 488 nm) versus electrical conductivity measured for PBTTT-C14 target films macroscopically doped with BCF using a thermal stimulus (see Example 5). The calibration data of *r*_{R} as a function of electrical conductivity *σ* is shown in Fig. 13(C), with representative Raman spectra shown in Fig. 13(D) (spectral positions of relevant peaks indicated by the asterisks). The maximum electrical conductivity values within the modified regions were hence determined via spectroscopic mapping of *r*_{R}, as in Example 7.

As shown in Fig. 13(B), maximal electrical conductivity of about 7 S/cm is obtained using *v* = 10 µm/s and *P* = 7 mW. The data also shows that high values of conductivity may also be obtained for *v* up to about 3 mm/s, as required for optimal high-throughput fabrication, provided that the laser power is sufficiently high. Further improvements may be achieved by employing pulsed, rather than continuous-wave, laser sources to minimize the simultaneous occurrence of overheating-induced de-doping.

### Example 10: Modification of composition and electrical conductivity of a PBTTT-C14 target film (2) by means of light stimulus for providing an RFID-antenna-type structure.

Onto glass substrates (1), a PBTTT-C14 target film (2) was deposited as described in Example 9.

In order to avoid any temperature-dependent changes in polymer crystallinity accompanying subsequent application of thermal stimulus, the resulting film (2) was then crystallised by annealing at 180 °C under nitrogen atmosphere followed by slow cooling to room temperature.

pNaSS transitory interlayer (3) and donor layer (4) comprising BCF were then deposited as described in Example 9.

Afterwards, the output of a 532 nm laser (8) was directed at the sample through the donor layer, as shown in Fig. 7(A), and focused about 20 µm above the PBTTT-C14 target film (2), as described in Example 9. Constant laser power *P* = 7 mW was used. The sample was continuously scanned in the focal plane of the laser (8) at speed *v* = 3 µm/s.

The residual BCF donor layer (4) and pNaSS transitory interlayer (3) were then removed as described in Example 9.

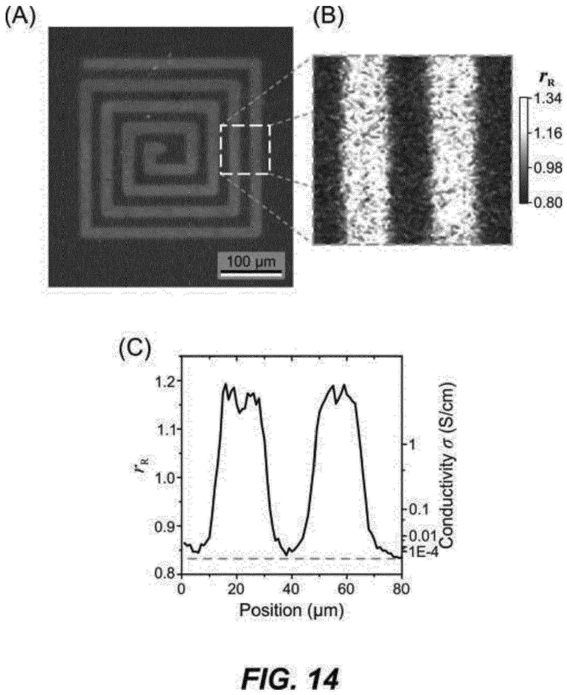

Transmitted-light micrograph of the obtained PBTTT-C14 target film (2) (Fig. 14(A)) shows a pattern of p-doping and, therewith, increased electrical conductivity in the form of a spiral with outer dimensions of 280×280 µm². Hence, herein exposure of the sample to scanning laser irradiation at selected location provides a continuous and homogeneous structure comprising a conductive line embedded in an otherwise semiconducting target film (2). Such structures may be employed as antennas for radio-frequency identification (RFID) tags. An image of *r*_{R} (1393 cm⁻¹ : 1417 cm⁻¹; recorded with excitation at 488 nm) was obtained for a selected sample region as described in Example 9 and is shown in Fig. 14(B). The corresponding average profile of *r*_{R} and electrical conductivity *σ* (Fig. 14(C)) shows a close match for the maximum *r*_{R} and, therewith, *σ* values for two adjacent conductive lines of the spiral pattern, with a maximum conductivity of about 3 S/cm, highlighting the homogeneity of modified electrical characteristics. Fig. 14(C) also confirms that the obtained PBTTT-C14 target film (2) retains the electrical conductivity of pristine, undoped PBTTT-C14 (*σ* ≈ 4×10-⁵ S/cm; indicated by the dashed line in Fig. 14(C)) outside laser-irradiated regions.

### Example 11: Effect of the transitory interlayer on the homogeneity of deposited donor layers.

Onto glass substrates (1), films of PBTTT-C14 target (2) (thickness approximately 43 nm) were spin-coated from a 1.5 wt% solution in chlorobenzene at 4000 rpm, with both solution and substrates (1) pre-heated to 110 °C prior to deposition.

The resulting films were then crystallised by annealing at 180 °C under nitrogen atmosphere followed by slow cooling to room temperature.

Four samples have been prepared herein.
- Onto two samples pNaSS transitory interlayer (3) was then spin-coated from a 2 wt% solution in water, additionally containing about 1 wt% of Triton X-100 surfactant added relative to the amount of solvent, at 6000 rpm (thickness approximately 80 nm).
- Other two samples remained uncoated, that is: without pNaSS transitory interlayer (3).

Thereafter, two different donor layers (4) were deposited:
- BCF: spin-coated from a 40 wt% solution in 10:1 wt/wt diethyl ether:methanol at 6000 rpm;
- 2:1 wt/wt BCF:biphenyl (BP): spin-coated from a 50 wt% solution in 10:1 wt/wt diethyl ether:methanol at 6000 rpm.

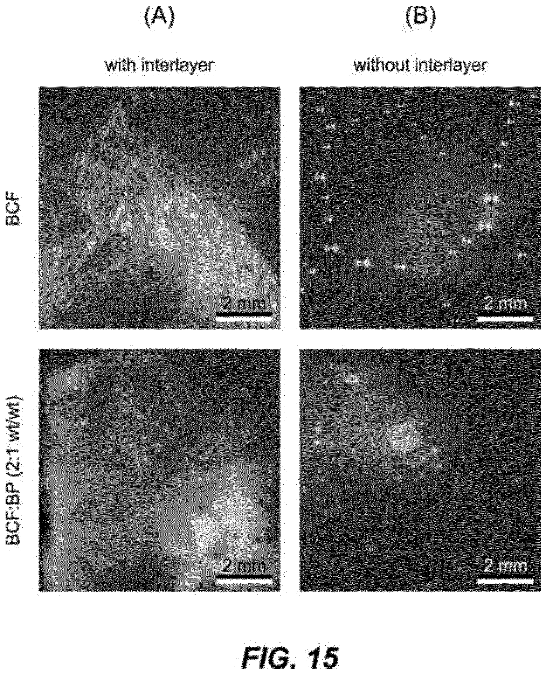

Transmitted-light micrographs of the obtained samples are shown in Fig. 15. The presence of the hydrophilic pNaSS transitory interlayer (3) enables optimal wetting of solutions used to deposit BCF and BCF+BP donor layers (4), thereby yielding homogeneous crystalline deposited donor layers (4) (Fig. 15(A)).

On the contrary, BCF and BCF+BP donor layer solutions deposited directly onto the hydrophobic PBTTT-C14 target film (2) do not form homogeneous layers, instead yielding isolated regions (Fig. 15(B)).

### Example 12: Stability of the thermal stimulus modified target layer (2) after chemical removal of the donor layer (4) and the transitory interlayer (3).

Onto a glass substrate (1), a PBTTT-C14 target film (2) (thickness approximately 43 nm) was spin-coated from a 1.5 wt% solution in chlorobenzene at 4000 rpm, with both solution and substrate (1) pre-heated to 110 °C prior to deposition.

In order to avoid any temperature-dependent changes in polymer crystallinity accompanying subsequent application of thermal stimulus, the resulting film (2) was then crystallised by annealing at 180 °C under nitrogen atmosphere followed by slow cooling to room temperature.

pNaSS transitory interlayer (3) was then spin-coated from a 2 wt% solution in water, additionally containing about 1 wt% of Triton X-100 surfactant added relative to the amount of solvent, at 6000 rpm (thickness approximately 80 nm).

Thereafter, a donor layer (4) comprising BCF was spin-coated from a 57 wt% BCF solution in 9:1 wt/wt diethyl ether:methanol at 8000 rpm.

The sample was then thermally annealed in air for 30 s at 120 °C to dope the PBTTT-C14 target film (2).

It is desirable that the modification of composition and electrical conductivity of the target layer (2) is not substantially affected by subsequent chemical removal of donor layer (4) and transitory interlayer (3). Herein, electrical conductivity of obtained sample was measured after sequential exposure to the liquid solvents used for removing the residual donor layer and transitory interlayer, whereby the sample was spun at 5000 rpm and a selected volume of a given solvent was deposited.

The BCF donor layer (4) can be removed by any solvents of BCF, include those used to deposit said donor layer (4) (that is, diethyl ether and methanol) as well as other organic solvents such as acetonitrile. Electrical conductivity of the thermal stimulus modified target layer (2) remains essentially constant at 24 S/cm following deposition of 100 µL of acetonitrile and, therewith, complete removal of the donor layer (4). This indicates that electrical conductivity of the modified target layer (2) is preserved after this process.

The transitory interlayer (3) can be removed by any solvents of the material comprising said layer. Herein, pNaSS transitory interlayer (3) can be removed by water which is good solvent for pNaSS. Electrical conductivity of the thermal stimulus modified target layer (2) shows a minor decrease to 20 S/cm following deposition of 100 µL of water and, therewith, complete removal of the transitory interlayer (3). This indicates that electrical conductivity of the modified target layer (2) is substantially preserved after this process.

Hence, it is shown that the removal of the residual donor layer (4) and transitory interlayer (3) by wet chemical means can be performed without appreciable deterioration of the induced modification.

### Example 13: Stability of the target layer (2) after physical and chemical removal of the transitory interlayer (3)

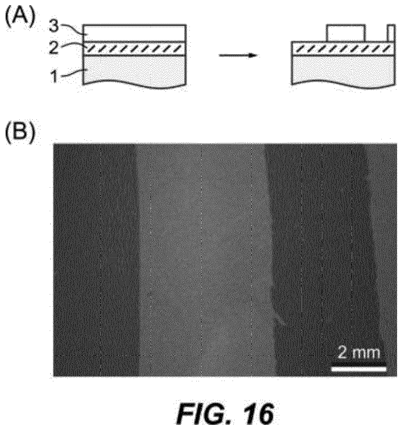

As shown in Fig. 16(A), onto a glass substrate (1) a P3HT target film (2) was spin-coated from a 2 wt% solution in chlorobenzene at 4000 rpm (thickness approximately 90 nm), with both solution and substrate (1) pre-heated to 55 °C prior to deposition.

pNaSS transitory interlayer (3) was then spin-coated from a 2 wt% solution in water, additionally containing about 1 wt% of Triton X-100 surfactant added relative to the amount of solvent, at 6000 rpm (thickness approximately 80 nm).

For some applications in electronic and photovoltaic devices it may be advantageous to minimise exposure of target layer (2) to solvents used for removing the transitory interlayer (3) such as water. Hence, it may be desirable to remove the transitory interlayer (3) by physical means, rather than chemical means used in the preceding examples.

To demonstrate that both methods can be used for removing the transitory interlayer (3), a part of the transitory interlayer (3) on the left side of the sample was then removed by partial immersion of the sample in water (see. Fig. 16(A)).

Another part of the transitory interlayer (3) on the right side of the sample was then removed by imprinting and lift-off using a conformal-contact-forming stamp of a polydimethylsiloxane (PDMS) elastomer.

In both cases, complete equivalent removal of the pNaSS transitory interlayer (3) is confirmed by the reflected-light optical micrographs shown in Fig. 16(B), which further highlight that no damage occurs to the target layer (2) by employing the solvent-free physical process.

## Claims

1. A method for providing a structural and/or a compositional modification in a molecular semiconductor target film (2) located onto a substrate (1), said method comprising the following steps:
a) depositing a semipermeable transitory interlayer (3) onto the molecular semiconductor target film (2) located onto a substrate (1) by means of solution-based deposition techniques,
b) depositing a solid donor layer (4) comprising a plurality of functional molecular additives onto the semipermeable transitory interlayer (3) obtained in step (a) by means of solution-based deposition techniques,
c) locally exposing the structure obtained in step (b) to thermal, solvent vapour or light stimulus, and
d) chemical or physical removal of the solid donor layer (4) and of the semipermeable transitory interlayer (3).
wherein the molecular semiconductor target film (2) is deposited onto a substrate (1) by means of solution-based deposition techniques,
wherein the composition of the semipermeable transitory interlayer (3) is selected from a group of polymers insoluble in the solvents and at the deposition conditions used for solution-based deposition of the molecular semiconductor target film (2) and of the donor layer (4),
wherein, in step (b), the semipermeable transitory interlayer (3) is impermeable at the deposition conditions and is configured to prevent the diffusion of functional molecular additives into the molecular semiconductor target film (2), and
wherein, in step (c), the semipermeable transitory layer (3) is permeable under the exposure of a thermal, solvent vapour or light stimulus and is configured to allow the locally diffusion of the plurality of functional molecular additives into the molecular semiconductor target film (2).

2. The method according to claim 1, wherein the molecular semiconductor target film (2) is deposited onto a substrate (1) by means of a technique selected from spin-coating, blade-coating, spray-coating, slot-die coating and combinations thereof.

3. The method according to any of claims 1 or 2, wherein step (a) and step (b) is performed by a technique selected from spin-coating, blade-coating, spray-coating, slot-die coating and combinations thereof.

4. The method according to any of claims 1 to 3, wherein the plurality of functional molecular additives of the donor layer (4) are selected from solvents, dyes, light-emitting dyes, nucleating agents, cross-linking agents, reactive monomers, catalysts, antigens, antibiotics, amino acids, oligopeptides, molecular electron acceptors, molecular electron donors, molecular electrical dopants and combinations thereof.

5. The method according to any of claims 1 to 4, wherein the structure obtained in step (b) is exposed to thermal, solvent vapour or light stimulus patternwise.

6. The method according to any of claims 1 to 5, wherein the structure obtained in step (b) is exposed to thermal stimulus by means of a hot plate (5), hot tip, hot stamp or hot gas in step (c).

7. The method according to any of claims 1 to 5, wherein the structure obtained in step (b) is exposed to solvent vapour stimulus by means of a nozzle (6) or a slot-die (7) in step (c).

8. The method according to any of claims 1 to 5, wherein at least the substrate (1), the molecular semiconductor target film (2), the semipermeable transitory interlayer (3) or the donor layer (4) is a light-absorbing layer.

9. The method according to any of claims 1 to 5, wherein the substrate (1) comprises a light-absorbing layer (9).

10. The method according to any of claims 8 or 9, wherein the structure obtained in step (b) is exposed to light stimulus by means of a laser (8) or a flash lamp.

## Patentansprüche

1. Verfahren zum Bereitstellen einer strukturellen und/oder kompositionellen Modifizierung in einem molekularen Halbleiterzielfilm (2), der sich auf einem Substrat (1) befindet, wobei das Verfahren folgende Schritte umfasst:
a) Abscheiden einer semipermeablen Übergangszwischenschicht (3) auf dem molekularen Halbleiterzielfilm (2), der sich auf einem Substrat (1) befindet, mittels lösungsbasierter Abscheidetechniken,
b) Abscheiden einer festen Donatorschicht (4), umfassend eine Vielzahl von funktionellen molekularen Zusatzstoffen, auf die in Schritt (a) erhaltene semipermeable Übergangszwischenschicht (3) mittels lösungsbasierter Abscheidetechniken,
c) lokales Aussetzen der in Schritt (b) erhaltenen Struktur einem Wärme-, Lösungsmittel-Dampf- oder Lichtstimulus, und
d) chemisches oder physisches Entfernen der festen Donatorschicht (4) und der semipermeablen Übergangszwischenschicht (3),
wobei der molekulare Halbleiterzielfilm (2) mittels lösungsbasierter Abscheidetechniken auf ein Substrat (1) abgeschieden wird,
wobei die Zusammensetzung der semipermeablen Übergangszwischenschicht (3) aus einer Gruppe von Polymeren ausgewählt wird, die in den Lösungsmitteln und bei den Abscheidebedingungen unlöslich sind, die für die lösungsbasierte Abscheidung des molekularen Halbleiterzielfilms (2) und der Donatorschicht (4) verwendet werden,
wobei in Schritt (b) die semipermeable Übergangszwischenschicht (3) bei den Abscheidebedingungen nicht permeabel ist und ausgebildet ist, um die Diffusion von funktionellen molekularen Zusatzstoffen in den molekularen Halbleiterzielfilm (2) zu verhindern, und
wobei in Schritt (c) die semipermeable Übergangsschicht (3) bei Aussetzen einem Wärme-, Lösungsmittel-Dampf- oder Lichtreizes permeabel ist und ausgebildet ist, um die lokale Diffusion der Vielzahl von funktionellen molekularen Zusatzstoffen in den molekularen Halbleiterzielfilm (2) zu ermöglichen.

2. Verfahren nach Anspruch 1, wobei der molekulare Halbleiterzielfilm (2) auf ein Substrat (1) mittels einer Technik abgeschieden wird, die aus Rotationsbeschichtung, Rakelbeschichtung, Sprühbeschichtung, Schlitzdüsen-Beschichtung und Kombinationen davon ausgewählt wird.

3. Verfahren nach einem der Ansprüche 1 oder 2, wobei Schritt (a) und Schritt (b) mittels einer Technik durchgeführt wird, die aus Rotationsbeschichtung, Rakelbeschichtung, Sprühbeschichtung, Schlitzdüsen-Beschichtung und Kombinationen davon ausgewählt wird.

4. Verfahren nach einem der Ansprüche 1 bis 3, wobei die Vielzahl der funktionellen molekularen Zusatzstoffe der Donatorschicht (4) aus Lösungsmitteln, Farbstoffen, lichtemittierenden Farbstoffen, Keimbildnern, Vernetzungsmitteln, reaktiven Monomeren, Katalysatoren, Antigenen, Antibiotika, Aminosäuren, Oligopeptiden, molekularen Elektronenakzeptoren, molekularen Elektronendonatoren, molekularen elektrischen Dotierstoffen und Kombinationen davon ausgewählt sind.

5. Verfahren nach einem der Ansprüche 1 bis 4, wobei die in Schritt (b) erhaltene Struktur einem Wärme-, Lösungsmittel-Dampf- oder Lichtreiz mustermäßig ausgesetzt wird.

6. Verfahren nach einem der Ansprüche 1 bis 5, wobei die in Schritt (b) erhaltene Struktur in Schritt (c) einem Wärmereiz mittels einer Heizplatte (5), einer heißen Spitze, eines heißen Stempels oder eines heißen Gases ausgesetzt wird.

7. Verfahren nach einem der Ansprüche 1 bis 5, wobei die in Schritt (b) erhaltene Struktur in Schritt (c) mittels eines Mundstücks (6) oder einer Schlitzdüse (7) einem Lösungsmittel-Dampf-Reiz ausgesetzt wird.

8. Verfahren nach einem der Ansprüche 1 bis 5, wobei mindestens das Substrat (1), der molekulare Halbleiterzielfilm (2), die semipermeable Übergangszwischenschicht (3) oder die Donatorschicht (4) eine lichtabsorbierende Schicht ist.

9. Verfahren nach einem der Ansprüche 1 bis 5, wobei das Substrat (1) eine lichtabsorbierende Schicht (9) umfasst.

10. Verfahren nach einem der Ansprüche 8 oder 9, wobei die in Schritt (b) erhaltene Struktur mittels eines Lasers (8) oder einer Blitzlampe einem Lichtreiz ausgesetzt wird.

## Revendications

1. Procédé de fourniture d'une modification de structure et/ou de composition dans un film cible moléculaire à semiconducteurs (2) situé sur un substrat (1), ledit procédé comprenant les étapes suivantes :
a) déposer une couche intermédiaire transitoire semiperméable (3) sur le film cible moléculaire à semiconducteurs (2) situé sur un substrat (1) par le biais de techniques de dépôt en solution,
b) déposer une couche donneuse solide (4) comprenant une pluralité d'additifs moléculaires fonctionnels sur la couche intermédiaire transitoire semiperméable (3) obtenue dans l'étape (a) par le biais de techniques de dépôt en solution,
c) exposer localement la structure obtenue dans l'étape (b) à des stimulus thermiques, de vapeur de solvant ou lumineux, et
d) retirer par voie chimique ou physique la couche donneuse solide (4) et la couche intermédiaire transitoire semiperméable (3) ;
dans lequel le film cible moléculaire à semiconducteurs (2) est déposé sur un substrat (1) par le biais de techniques de dépôt en solution,
dans lequel la composition de la couche intermédiaire transitoire semiperméable (3) est choisie parmi un groupe de polymères insolubles dans les solvants et dans les conditions de dépôt utilisées pour le dépôt en solution du film cible moléculaire à semiconducteurs (2) et de la couche donneuse (4),
dans lequel, dans l'étape (b), la couche intermédiaire transitoire semiperméable (3) est imperméable dans les conditions de dépôt et est configurée pour empêcher la diffusion d'additifs moléculaires fonctionnels dans le film cible moléculaire à semiconducteurs (2), et
dans lequel, dans l'étape (c), la couche transitoire semiperméable (3) est perméable sous l'exposition à un stimulus thermique, de vapeur de solvant ou lumineux et est configurée pour permettre la diffusion locale de la pluralité d'additifs moléculaires fonctionnels dans le film cible moléculaire à semiconducteurs (2).

2. Procédé selon la revendication 1, dans lequel le film cible moléculaire à semiconducteurs (2) est déposé sur un substrat (1) par le biais d'une technique choisie parmi le revêtement par centrifugation, le revêtement à la lame, le revêtement par pulvérisation, le revêtement par filière plate et des combinaisons de ceux-ci.

3. Procédé selon l'une quelconque des revendications 1 ou 2, dans lequel l'étape (a) et l'étape (b) sont réalisées par une technique choisie parmi le revêtement par centrifugation, le revêtement à la lame, le revêtement par pulvérisation, le revêtement par filière plate et des combinaisons de ceux-ci.

4. Procédé selon l'une quelconque des revendications 1 à 3, dans lequel la pluralité d'additifs moléculaires fonctionnels de la couche donneuse (4) sont choisis parmi des solvants, des colorants, des colorants émetteurs de lumière, des agents de nucléation, des agents de réticulation, des monomères réactifs, des catalyseurs, des antigènes, des antibiotiques, des acides aminés, des oligopeptides, des accepteurs d'électrons moléculaires, des donneurs d'électrons moléculaires, des dopants électriques moléculaires et des combinaisons de ceux-ci.

5. Procédé selon l'une quelconque des revendications 1 à 4, dans lequel la structure obtenue dans l'étape (b) est exposée à un stimulus thermique, de vapeur de solvant ou lumineux selon un motif.

6. Procédé selon l'une quelconque des revendications 1 à 5, dans lequel la structure obtenue dans l'étape (b) est exposé á un stimulus thermique par le biais d'une plaque chauffante (5), d'une pointe chaude, d'un tampon chaud ou d'un gaz chaud dans l'étape (c).

7. Procédé selon l'une quelconque des revendications 1 à 5, dans lequel la structure obtenue dans l'étape (b) est exposée à un stimulus de vapeur de solvant par le biais d'une buse (6) ou d'une filière plate (7) dans l'étape (c).

8. Procédé selon l'une quelconque des revendications 1 à 5, dans lequel au moins le substrat (1), le film cible moléculaire à semiconducteurs (2), la couche intermédiaire transitoire semiperméable (3) ou la couche donneuse (4) est une couche absorbant de la lumière.

9. Procédé selon l'une quelconque des revendications 1 à 5, dans lequel le substrat (1) comprend une couche absorbant de la lumière (9).

10. Procédé selon l'une quelconque des revendications 8 ou 9, dans lequel la structure obtenue dans l'étape (b) est exposée à un stimulus lumineux par le biais d'un laser (8) ou d'une lampe flash.
